# EUROPEAN PATENT APPLICATION

(11) **EP 4 250 382 A1**
(43) Date of publication of application: **27.09.2023**
(21) Application number: 21895034.3
(22) Date of filing: 15.11.2021
(51) Int. Cl.: H01L 51/52, G09F 9/30, H05B 33/04

(54) **STRETCHABLE ENCALSULANTION MATERIAL**

(30) Priority: 18.11.2020 KR 20200154171
(71) Applicant: Korea University Research and Business Foundation, Seoul 02841 (KR)
(72) Inventor: HAN, Chang Soo, Seoul 04428 (KR); CHOI, Byoung Ho, Seoul 01197 (KR); JO, Sung Hwan, Seoul 02578 (KR); SONG, Seung Hak, Seoul 02855 (KR); WOO, Ju Yeon, Icheon-si Gyeonggi-do 17332 (KR); JEON, Eun Seok, Yongin-si Gyeonggi-do 16916 (KR)
(74) Representative: V.O.
(86) International application number: PCT/KR2021/016604
(87) International publication number: WO 2022/108266

(57) **Abstract**

A stretchable encapsulant according to the present invention includes a wrinkle part having a stretchable wrinkle structure; and a packaging part being in close contact with the wrinkle part and configured to wrap the wrinkle part, wherein the wrinkle part has a multi-layered structure wherein an organic material and an inorganic material are mutually laminated. According to such a configuration, high stretchability and low gas and moisture permeability due to the composite structure of the organic and inorganic materials of the multi-layered structure together with high stretchability due to the hierarchical structure can be provided.

## Description

### [Cross-Reference to Related Application]

This application is a National Stage Entry of PCT International Application No. PCT/KR2021/016604, which was filed on November 15, 2021, and which claims priority to Korean Patent Application No. 10-2020-0154171, filed on November 18, 2020 in the Korean Intellectual Property Office, the disclosure of which is incorporated herein by reference.

### [Technical Field]

The present invention relates to a stretchable encapsulant, and more particularly to a stretchable encapsulant having high stretchability and low gas and moisture permeability by using a hierarchical composite structure of organic and inorganic materials.

### [Background Art]

The display industry has entered a mature stage based on Liquid Crystal Display (LCD). In recent years, market competition is accelerating as the market diversifies with the advent of Organic Light Emitting Diodes (OLEDs), and the demand for next-generation displays that can create high-added value is increasing.

This display industry is technically evolving in the order of bendable, rollable, foldable, and stretchable. However, in the foldable field of current display industry technology, it has not been implemented to a level where various folds are possible, such as folding newspapers.

Meanwhile, OLEDs, which are mainly used for flexible devices, are very vulnerable to moisture and oxygen, so an encapsulant of a certain level is required. Since such existing encapsulant technology uses a method of depositing an inorganic material layer with vacuum equipment and since the thickness of a manufactured thin film is 1 µm or more, it has the disadvantage of breaking when bent or stretched. Thereby, in recent years, several studies are in progress to compensate for the disadvantages of an encapsulant for the application of next-generation displays.

### [Disclosure]

### [Technical Problem]

Therefore, the present invention has been made in view of the above problems, and it is one object of the present invention to provide a stretchable encapsulant capable of providing stretchability and low gas and moisture permeability by using a hierarchical composite structure of organic and inorganic materials.

### [Technical Solution]

In accordance with an aspect of the present invention, the above and other objects can be accomplished by the provision of a stretchable encapsulant having a multi-layered structure, the stretchable encapsulant including: a wrinkle part having a stretchable wrinkle structure; and a packaging part being in close contact with the wrinkle part and configured to wrap the wrinkle part, wherein the wrinkle part has a multi-layered structure wherein an organic material and an inorganic material are mutually laminated.

In addition, the wrinkle part may have at least one shape of a periodic or aperiodic one-dimensional, two-dimensional or three-dimensional wave, wrinkle and protrusion shape.

In addition, the wrinkle part may be prepared using at least one of nanoimprint, lithography, hot embossing and a wrinkle forming method using a previously stretched substrate.

In addition, the wrinkle part may have a brick-mortar structure made of a plurality of bricks formed of the inorganic material; and a mortar formed of the organic material for fixing the plural bricks to each other.

In addition, the plural bricks may include at least one of nanoclay including bentonite and montmorillonite and an oxide-based ceramic group including calcium carbonate, silica, alumina and titanium oxide, and the mortar may include one or more selected from a stretchable polymer group including polydimetylsiloxane (PDMS), polyurethane acrylate (PUA), perfluoropolyether (PFPE) and polyester (PE) or composite materials of the stretchable polymer materials and is made of a material having greater stretchability and elasticity than the bricks.

In addition, an aspect ratio of the plural bricks may be 10 or more, and a length of the plural bricks may be more than 10 times greater than an interval between the plural bricks.

In addition, the plural bricks may include: a multi-layered brick-mortar unit including a plurality of brick elements formed of the inorganic material and a mortar element formed of the organic material to fix the plural brick elements to each other, or a multi-layered unit wherein a plurality of inorganic brick layers formed of the inorganic material and a plurality of organic brick layers formed of the organic material are alternately and sequentially laminated.

In addition, the plural brick elements or the inorganic brick layer may be formed of at least one of an oxide-based ceramic group including calcium carbonate, silica, alumina and titanium oxide, and the mortar element or the organic brick layer may include one or more selected from among a stretchable polymer group including polydimetylsiloxane (PDMS), polyurethane acrylate (PUA), perfluoropolyether (PFPE) and polyester (PE) or composite materials of the stretchable polymer materials and is made of a material having greater stretchability and elasticity than the plural brick elements or the inorganic brick layer.

In addition, the wrinkle part may have a layered structure wherein a plurality of inorganic layers formed of the inorganic material and a plurality of organic layers formed of the organic material are alternately and sequentially laminated.

In addition, the plural inorganic layers may include at least one of an oxide-based ceramic group including calcium carbonate, silica, alumina and titanium oxide, and the plural organic layers may include one or more selected from a stretchable polymer group including polydimetylsiloxane (PDMS), polyurethane acrylate (PUA), perfluoropolyether (PFPE) and polyester (PE) or composite materials of the stretchable polymer materials and are made of a material having greater stretchability and elasticity than the plural inorganic layers.

In addition, the plural inorganic layers may be deposited by an Atomic Layer Deposition (ALD) process, and the plural organic layers may include a metalcone film including alucone or zincone and are deposited by a Molecular Layer Deposition (MLD) process.

In addition, pores may be formed at different positions of the plural inorganic layers to extend a permeation path of gas and moisture.

In addition, the plural inorganic layers may include: a multi-layered brick-mortar unit including a plurality of brick elements formed of the inorganic material and a mortar element formed of the organic material to fix the plural brick elements to each other, or a multi-layered unit wherein a plurality of inorganic elements formed of the inorganic material and a plurality of organic elements formed of the organic material are alternately and sequentially laminated.

In addition, the plural brick elements or the inorganic elements may be formed of at least one of an oxide-based ceramic group including calcium carbonate, silica, alumina and titanium oxide, and the mortar element or the organic elements may include one or more selected from a stretchable polymer group including polydimetylsiloxane (PDMS), polyurethane acrylate (PUA), perfluoropolyether (PFPE) and polyester (PE) or composite materials of the stretchable polymer materials and are made of a material having greater stretchability and elasticity than the plural brick elements or the inorganic elements.

In addition, the packaging part may be formed of a polymer material having greater elasticity and stretchability than the wrinkle part.

In accordance with another aspect of the present invention, there is provided a stretchable encapsulant having a multi-layered structure, the stretchable encapsulant including: a wrinkle part having a periodic or aperiodic pleated shape and being stretchable; and a packaging part having greater elasticity and stretchability than the wrinkle part and being in close contact with the wrinkle part to wrap the wrinkle part, wherein the wrinkle part has a multi-layered structure wherein an organic material and an inorganic material are mutually laminated.

In addition, the wrinkle part may have at least one shape of a periodic or aperiodic one-dimensional, two-dimensional or three-dimensional wave, wrinkle and protrusion shape and may be prepared using at least one of nanoimprint, lithography, hot embossing and a wrinkle forming method using a previously stretched substrate.

In addition, the inorganic material may include at least one of nanoclay including bentonite and montmorillonite and an oxide-based ceramic group including calcium carbonate, silica, alumina and titanium oxide, and the organic material may include one or more selected from a stretchable polymer group including polydimetylsiloxane (PDMS), polyurethane acrylate (PUA), perfluoropolyether (PFPE) and polyester (PE) or composite materials of the stretchable polymer materials and is made of a material having greater stretchability and elasticity than the bricks.

In addition, the wrinkle part may have a brick-mortar structure including a plurality of bricks formed of the inorganic material and a mortar formed of the organic material to fix the plural bricks to each other or a layered structure wherein a plurality of inorganic layers formed of the inorganic material and a plurality of organic layers formed of the organic material are alternately and sequentially laminated.

In addition, an aspect ratio of the plural bricks may be 10 or more, and a length of the plural bricks may be more than 10 times greater than an interval between the plural bricks.

In addition, the plural bricks may include: a multi-layered brick-mortar unit including a plurality of brick elements formed of the inorganic material and a mortar element formed of the organic material to fix the plural brick elements to each other, or a multi-layered unit wherein a plurality of inorganic brick layers formed of the inorganic material and a plurality of organic brick layers formed of the organic material are alternately and sequentially laminated.

In addition, the plural inorganic layers may be deposited by an Atomic Layer Deposition (ALD) process, and the plural organic layers may include a metalcone film including alucone or zincone and are deposited by a Molecular Layer Deposition (MLD) process.

In addition, pores may be formed at different positions of the plural inorganic layers to extend a permeation path of gas and moisture.

In addition, the plural inorganic layers may include: a multi-layered brick-mortar unit including a plurality of brick elements formed of the inorganic material and a mortar element formed of the organic material to fix the plural brick elements to each other, or a multi-layered unit wherein a plurality of inorganic elements formed of the inorganic material and a plurality of organic elements formed of the organic material are alternately and sequentially laminated.

### [Advantageous effects]

In accordance with the present invention having the above-described configuration, a wrinkle part has a pleated shape; and a multi-layered structure such as a hierarchical brick-mortar structure or a layered structure, thereby having high stretchability. In addition, a path for gas and moisture can be lengthily induced, compared to existing encapsulants, due to the multi-layered structure, thereby securing low gas and moisture permeability.

In addition, bricks or an inorganic layer made of an inorganic material forming the multi-layered structure can be formed of a smaller multi-layered structure, so that it is more advantageous to improve stretchability and lower gas and moisture permeability.

In addition, the encapsulant has a multi-layered structure and a pleated shape in combination, so that stress applied during high elasticity is low and thus the mechanical stability is excellent.

Further, a permeation path of gas and moisture can be extended longer compared to a single inorganic layer by making the positions of pores different for each of a plurality of inorganic layers, so that low moisture permeability can be expected.

### [Description of Drawings]

FIG. 1 is a perspective view schematically illustrating a stretchable encapsulant according to a preferred embodiment of the present invention.
FIG. 2 illustrates a three-dimensionally calculated image of the encapsulant shown in FIG. 1 through finite element analysis in a state in which the encapsulant is 30% tensioned.
FIG. 3 illustrates a schematic enlarged view of a permeation path of gas and moisture in a brick-mortar structure of the encapsulant shown in FIG. 1.
FIG. 4 is a graph schematically illustrating the comparison of moisture permeability over time in a brick-mortar structure of the encapsulant shown in FIG. 1.
FIG. 5 schematically illustrates results obtained by calculating the relationship between stress and strain, applied to the structure according to a material at 30% tension of the encapsulant shown in FIG. 1, by the finite analysis method.
FIG. 6 schematically illustrates the relationship between allowable strain and volume strain applied to the structure according to a material at 30% tension of the encapsulant shown in FIG. 1.
FIG. 7 is a perspective view schematically illustrating a stretchable encapsulant according to a preferred second embodiment of the present invention.
FIG. 8 is a perspective view schematically illustrating a stretchable encapsulant according to a preferred third embodiment of the present invention.
FIG. 9 is a perspective view schematically illustrating a stretchable encapsulant according to a preferred fourth embodiment of the present invention.
FIG. 10 is a perspective view schematically illustrating a stretchable encapsulant according to a preferred fifth embodiment of the present invention.
FIG. 11 is a perspective view schematically illustrating a stretchable encapsulant according to a preferred sixth embodiment of the present invention.

### [Best Mode]

Hereinafter, the present invention will be described in detail by explaining a preferred embodiment of the invention with reference to the attached drawings. However, it should be understood that the spirit and scope of the present invention are not limited to the embodiment and can be modified by addition, modification, or deletion of elements constituting the embodiment and such additions, modifications, and deletions are also within the spirit and scope of the present invention.

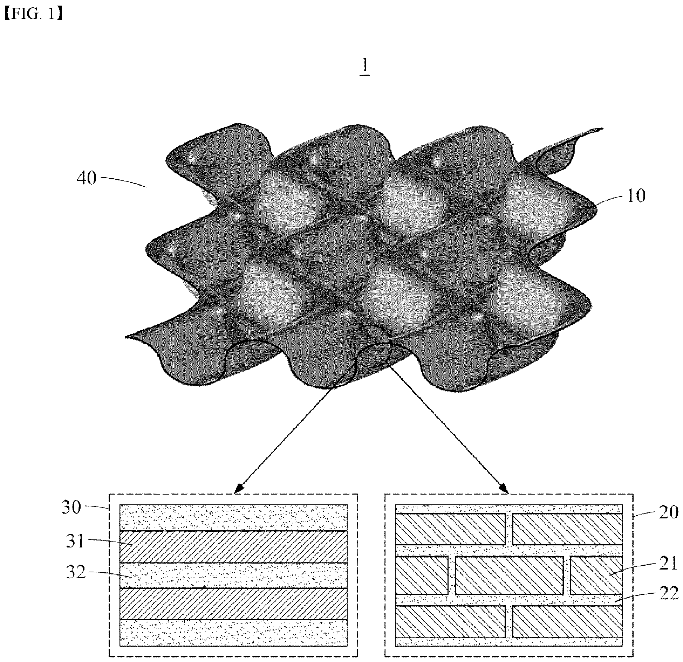

Referring to FIG. 1, a stretchable encapsulant 1 according to a first preferred embodiment of the present invention includes a wrinkle part 10 and a packaging part 40.

For reference, the stretchable encapsulant 1 described in the present invention may be applied to an OLED for implementing a foldable or stretchable display, but is not limited thereto.

The wrinkle part 10 has a pleated shape to be stretchable in a longitudinal direction. The wrinkle part 10 has a 1-dimensional, 2-dimensional or 3-dimensional wave or protrusion shape, thereby being stretchable. As shown in FIG. 1, the wrinkle part 10 according to the first embodiment is illustrated and exemplified as having a two-dimensional pleated shape, but is not necessarily limited thereto.

Meanwhile, the 2D wavy shape of the wrinkle part 10 does not necessarily have a period. That is, the wrinkle part 10 may have aperiodic wavy-shaped wrinkles to reduce optical scattering. The wrinkle part 10 may be wrinkled using nanoimprint, lithography, hot embossing, a wrinkle forming method using a previously stretched substrate, or the like.

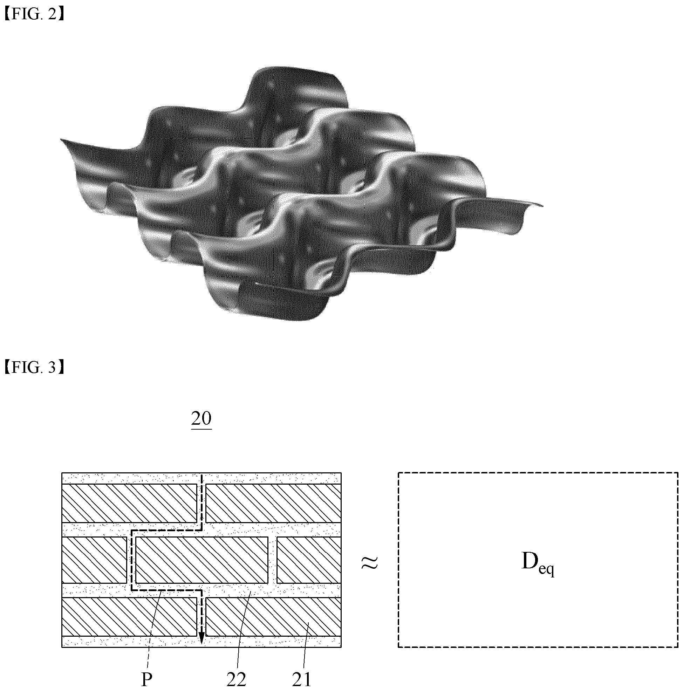

As the wrinkle part 10 is stretchable like a spring due to the wrinkles thereof as described above, the wrinkle structure itself may have stretchability. Referring to FIG. 2, a three-dimensionally calculated image of the wrinkle part 10 through finite element analysis is schematically shown. FIG. 2 illustrates a state in which the wrinkle part 10 is stretched by about 30%. From FIG. 2, it can be confirmed that tension is generated in the wrinkled area.

In addition, the wrinkle part 10 is provided with a wrinkle film having a multi-layer hierarchical structure formed of organic and inorganic materials. In addition, the wrinkle part 10 may have a brick-mortar structure 20 or a layered structure 30, as shown enlarged in FIG. 1.

First, the brick-mortar structure 20 of the wrinkle part 10 is described below.

In the brick-mortar structure 20, an inorganic material, i.e., an inorganic composite material, is provided in the form of a plurality of bricks 21, and an organic material, i.e., an organic composite material, is provided in the form of mortar 22 such as cement to fix between the plural bricks 21.

The plural bricks 21 may include at least one of oxide-based ceramics, i.e., groups including nanoclay, which includes bentonite and montmorillonite, calcium carbonate, silica, alumina and titanium oxide, as inorganic particles. In addition, the bricks 21 may have a plate-like structure of various sizes from micrometers to nanometers, and encapsulation performance may be controlled by adjusting an aspect ratio (A/B) of a horizontal length (A) to a vertical length (B) of the bricks 21.

In this embodiment, it is exemplified that the aspect ratio of the plural bricks 21 is 10 or more. More preferably, the plural bricks 21 has an aspect ratio of 100 or more, which induces a long gas and moisture permeation path P (see FIG. 3), thereby achieving low gas and moisture permeability. In addition, as shown in FIG. 3, the length D_{Brick} of the bricks 21 is 10 times or more, more preferably 100 times or more, of an interval Dₘₒᵣₜₐᵣ between the plural bricks 21. In this case, as shown in FIG. 3, it is advantageous to block the permeation of gas and moisture by inducing a long gas and moisture permeation path P (see FIG. 2).

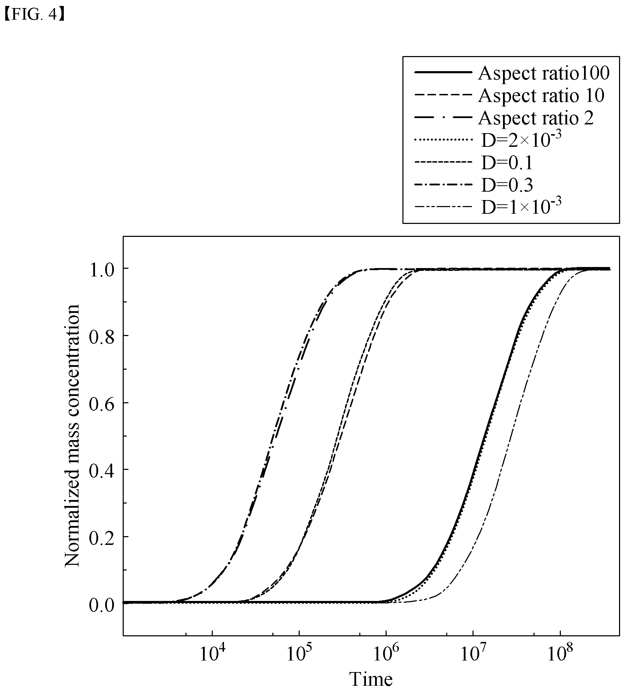

As shown in FIG. 4, an equivalent water permeability of the brick-mortar structure 20 may be calculated by deriving a time-moisture diffusivity correlation for the wrinkle part 10 having the brick-mortar structure 20 using finite element analysis. Referring to FIG. 4 showing the finite element analysis calculation result, it can be confirmed that the moisture permeability of the brick-mortar structure 20 is similar to that of inorganic bricks when the aspect ratio of the bricks 21 is 100 times or more.

As described above, the performance of an encapsulant 1 may be controlled by adjusting the aspect ratio of the plural bricks 21, the length of the plural bricks 21, and an interval between the plural bricks 21.

The mortar 22 is composed of an organic material or an organic composite, and is formed of a polymer material with relatively greater stretchability than the bricks 21 so that the plural bricks 21 are stretchable in a state of being firmly fixed to each other. For example, the mortar 22 may include one or more selected from a stretchable polymer group including polydimetylsiloxane (PDMS), polyurethane acrylate (PUA), perfluoropolyether (PFPE), and polyester (PE) or composite materials of the stretchable polymer materials. The mortar 22 may include any type of polymer having high elasticity.

Hereinafter, the layered structure 30 of the encapsulant 1 shown in FIG. 1 is described.

The layered structure 30 shown in FIG. 1 is formed by alternately and sequentially laminating a plurality of inorganic layers 31 made of an inorganic material and a plurality of organic layers 32 made of an organic material. Here, the thickness of each of the inorganic layers 31 and the organic layers 32 preferably ranges from several nanometers (nm) to hundreds of nanometers (nm).

Here, the inorganic layers 31 may be prepared using an Atomic Layer Deposition (ALD) process in which thin film layers can be layered in the unit of one atomic layer among semiconductor processes. In addition, the inorganic layers 31 may include at least one of an oxide-based ceramic group including oxide-based ceramics, e.g., calcium carbonate, silica, alumina and titanium oxide, like the above-described materials of the bricks 21. Due to the structure of the inorganic layers 31, low moisture permeability, i.e., low moisture penetrance, which is the main function of the encapsulant 1 may be secured.

Meanwhile, permeation of gas and moisture in the plural inorganic layers 31 occurs in pores created during processing or use. Accordingly, the layered structure 30 according to the present invention forms pores at different positions for each of the plural inorganic layers 31, thereby extending the permeation path of gas and moisture compared to the single structure of the inorganic layers 31 to achieve low moisture permeability.

In addition, the plural organic layers 32 are prepared with a stretchable polymer material with greater stretchability than the inorganic layers 31. That is, the plural organic layers 32 include one or more selected from a stretchable polymer group including polydimetylsiloxane (PDMS), polyurethane acrylate (PUA), perfluoropolyether (PFPE) and polyester (PE) or composite materials of the stretchable polymer materials, as in the mortar 22 and have stretchability and elasticity.

Here, the plural organic layers 32 are deposited using a Molecular Layer Deposition (MLD) process. In addition, the plural organic layers 32 may include a metalcone film, e.g., one or more selected from the group including alucone or zincone. Due to these plural organic layers 32, the film stress relief and flexibility of the encapsulant 1 may be improved.

Meanwhile, when the wrinkle part 10 described in the present invention is formed using atomic deposition, molecular deposition, roll-to-roll processing, and the like, there is an advantage in manufacturing a high-quality, large-area the encapsulant 1.

The packaging part 40 wraps and protects the wrinkle part 10. The packaging part 40 is made of a polymer material having greater elasticity and stretchability than the wrinkle part 10.

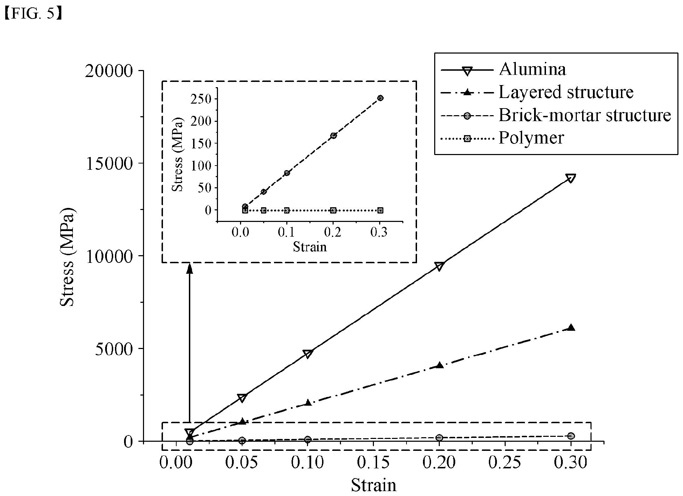

Referring to FIG. 5, the result of calculating the relationship between stress and strain applied to the structure according to a material at 30% tension of the encapsulant 1 by the finite analysis method is schematically shown. As shown in FIG. 5, it can be confirmed that the brick-mortar structure 20 and the layered structure 30 show high strain at low stress compared to conventional ceramic materials such as alumina.

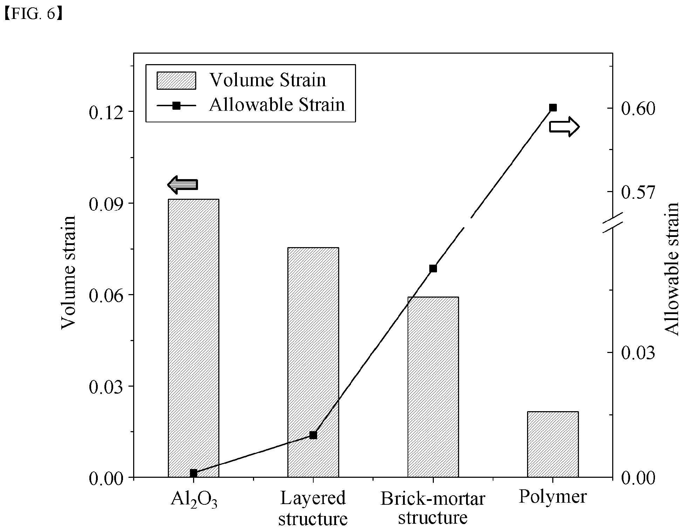

In addition, referring to FIG. 6, the result of calculating the relationship between allowable strain and volume strain applied to the structure according to a material at 30% tension of the encapsulant 1 by the finite analysis method is schematically shown. As shown in FIG. 6, it can be confirmed that both the brick-mortar structure 20 and the layered structure 30 have excellent stretchability compared to alumina which is a conventional ceramic material.

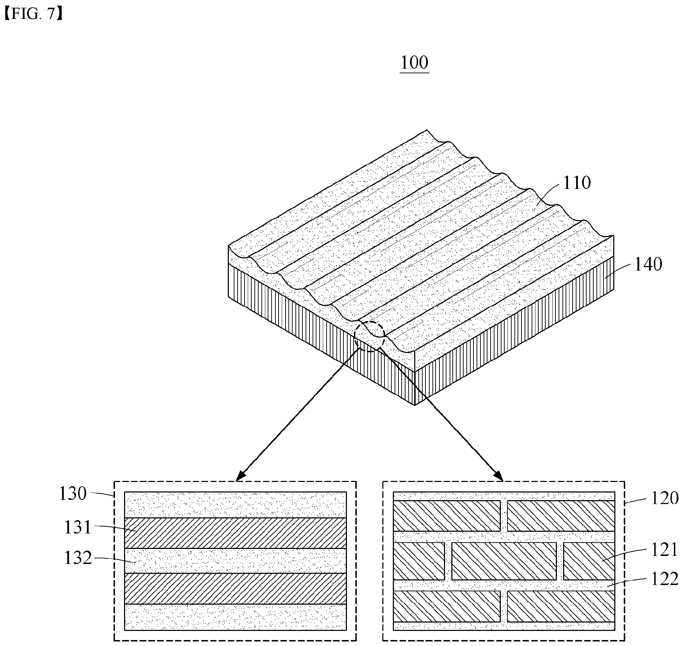

Referring to FIG. 7, a stretchable encapsulant 100 according to a preferred second embodiment of the present invention includes a wrinkle part 110 and a packaging part 140.

The wrinkle part 110 has a one-dimensional shape, more specifically a one-dimensional wave pattern. That is, the wrinkle part 110 according to the second embodiment has a one-dimensional wavy shape. This wavy shape is partially different from that of the first embodiment in that it is periodically or aperiodically provided.

The wrinkle part 110 has a multi-layered structure and may have either a brick-mortar structure 120 and a layered structure 130, as in the first embodiment described above. Here, the brick-mortar structure 120 includes a plurality of bricks 121 and a mortar 122 for fixing the plural bricks 121 to each other, and the layered structure 130 has a shape wherein an inorganic layer 131 and an organic layer 132 are alternately and repeatedly laminated. The brick-mortar structure 120 and the layered structure 130 have the same configurations as those of the first embodiment, a detailed description thereof is omitted.

The packaging part 140 is in close contact with the wrinkle part 110 and made of a stretchable material. The packaging part 140 also has a configuration similar to that of the packaging part 40 according to the first embodiment described above, so a detailed description thereof is omitted.

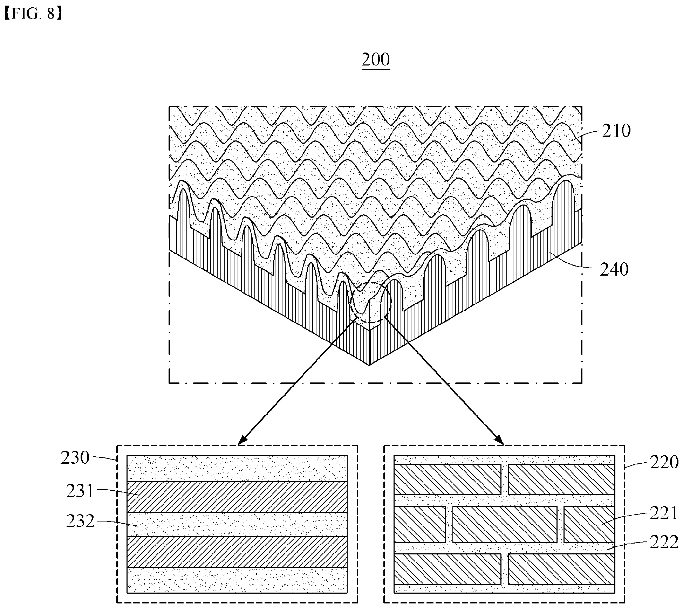

Referring to FIG. 8, a stretchable encapsulant 200 according to a third embodiment of the present invention is schematically illustrated.

Referring to FIG. 8, the encapsulant 200 according to the third embodiment includes a wrinkle part 210 and a packaging part 240. The configuration of the packaging part 240 is similar to that of the first embodiment, so a detailed description thereof is omitted.

The wrinkle part 210 according to the third embodiment has a periodic or aperiodic three-dimensional protrusion structure. In addition, the wrinkle part 210 according to the third embodiment may have a brick-mortar structure 220 including a plurality of bricks 221 and a mortar 222 for fixing the plural bricks 221, or a layered structure 230 wherein a plurality of inorganic layers 231 and a plurality of organic layers 232 are alternately laminated. The wrinkle part 210 according to the third embodiment has a three-dimensional protrusion structure, so it is distinguished from the first embodiment having a two-dimensional pleated shape. Other configurations except for the shape of the wrinkle part 210 are similar to those of the first embodiment, so a detailed description thereof is omitted.

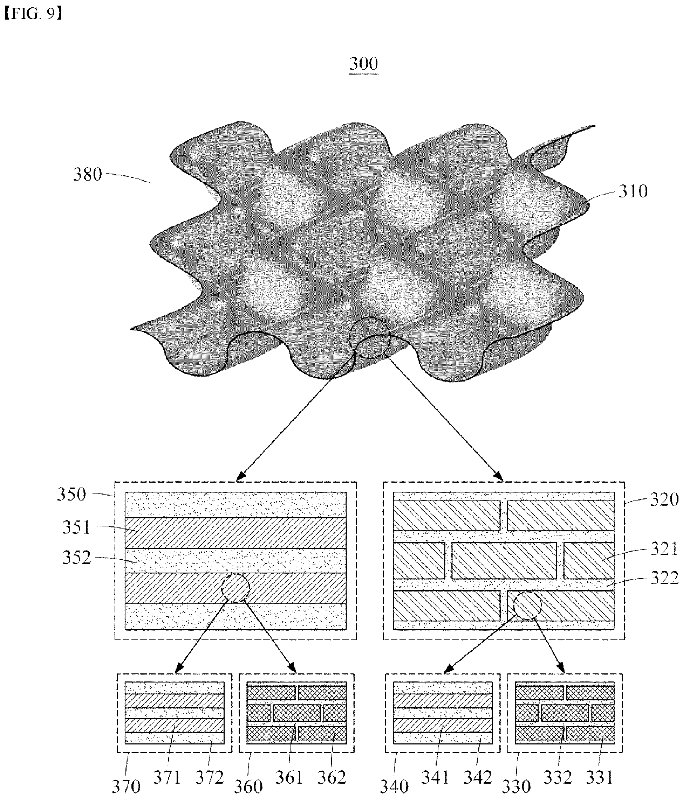

Referring to FIG. 9, a stretchable encapsulant 300 according to a preferred fourth embodiment of the present invention is schematically illustrated.

The stretchable encapsulant 300 according to the fourth embodiment includes a wrinkle part 310 and a packaging part 380. Here, the packaging part 380 has a configuration similar to that of the packaging part 40 of the first embodiment, so a detailed description thereof is omitted.

The wrinkle part 310 according to the fourth embodiment has a pleated shape having a two-dimensional period similar to that of the first embodiment and has a brick-mortar structure 320 or a layered structure 350. Here, the inorganic material of the brick-mortar structure 310 or the layered structure 350 has a multi-layered structure of a smaller unit.

More specifically, a plurality of bricks 321 forming the brick-mortar structure 320 includes a first brick-mortar unit 330 or a first layered unit 340. That is, the plural bricks 321 may be formed of the first brick-mortar unit 330 including a plurality of first brick elements 331 of a smaller unit and a first mortar element 332 for fixing the plural first brick elements 331 to each other. Alternatively, the plural bricks 321 may be formed of the first layered unit 340 wherein a plurality of thin film-shaped inorganic brick layers 341 and a plurality of thin film-shaped organic brick layers 342 are alternately and repeatedly laminated.

In addition, in a wrinkle film 310 of the layered structure 350, a plurality of inorganic layers 351 constituting the layered structure 350 has a multi-layered structure of a smaller unit including a second brick-mortar unit 360 or a second layered unit 370. More specifically, the plural inorganic layers 351 may be formed of the second brick-mortar unit 360 including a plurality of second brick elements 361 and a second mortar element 362 for fixing the plural second brick elements 361 to each other. Alternatively, the plural inorganic layers 351 may be formed of the second layered unit 370 wherein a plurality of thin film-shaped inorganic elements 371 and organic elements 372 are alternately and repeatedly laminated.

When the wrinkle part 310 according to the fourth embodiment is formed in the multi-layered structure as described above, the bricks 321 or the inorganic layers 351 are formed of the first and second brick-mortar units 330 and 360 or first and second layered structures 340 and 370 of a smaller unit. Accordingly, the hierarchically prepared bricks 321 or inorganic layers 351 of the wrinkle part 310 according to the fourth embodiment have a smaller hierarchical structure, thereby being more advantageous in securing tensile stress compared to the first to third embodiments.

In addition, since the bricks 321 or the inorganic layers 351 have the first and second brick-mortar units 330 and 360 or first and second layered structures 340 and 370 of a smaller unit, a more complicated path of gas and moisture may be provided. Accordingly, an encapsulant 300 according to the fourth embodiment may achieve relatively lower moisture permeability and gas permeability, compared to the first to third embodiments.

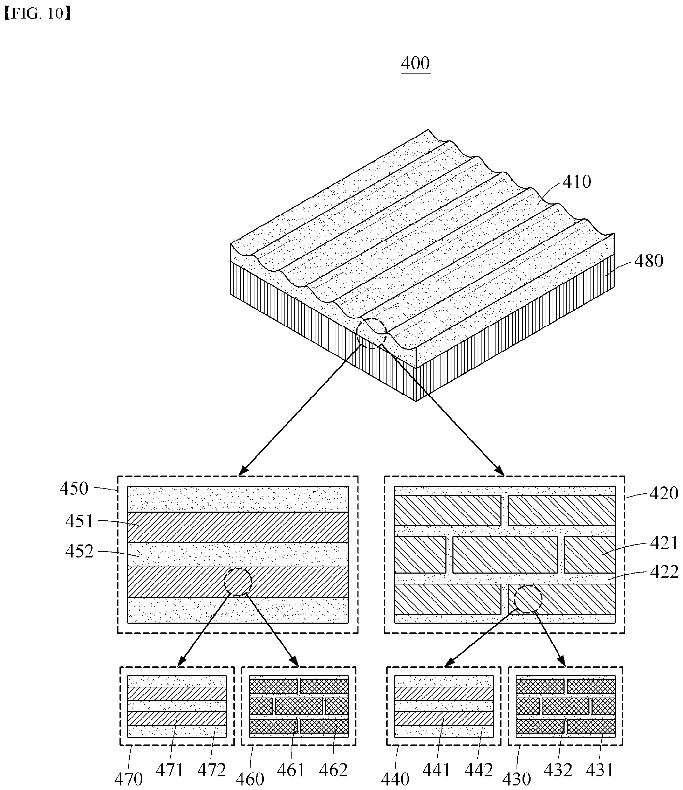

Referring to FIG. 10, a stretchable encapsulant 400 according to a fifth embodiment is schematically illustrated. The encapsulant 400 according to the fifth embodiment is similar to that of the second embodiment in that the encapsulant 400 includes a wavy-shaped wrinkle part 410 and packaging part 480 having a one-dimensional period.

Here, the wrinkle part 410 has a brick-mortar structure 420 or a layered structure 450, and each of the brick-mortar structure 420 and the layered structure 450 has first and second multilayer brick-mortar units 430 and 460 or first and second layered structures 440 and 470 of a small unit. That is, each of bricks 421 or inorganic layers 451 of the wrinkle part 410 according to the fifth embodiment is formed of hierarchically structured first and second brick-mortar units 430 and 460 or first and second layered structures 440 and 470 of a small unit, as in the fourth embodiment described above.

More specifically, each of the plural bricks 421 constituting the brick-mortar structure 420 is formed of a first brick-mortar unit 430 or a first layered unit 440. Here, the first brick-mortar unit 430 includes a plurality of first brick elements 431 and a first mortar element 432 for fixing the plural first brick elements 431 to each other, and the first layered unit 440 is formed by alternately and repeatedly laminating a plurality of thin film-shaped inorganic brick layers 441 and organic brick layers 442.

In addition, when the wrinkle film 410 has the layered structure 450, each of the plural inorganic layers 451 constituting the layered structure 450 is formed of a second brick-mortar unit 460 or a second layered unit 470. Here, the second brick-mortar unit 460 includes a plurality of second brick elements 461 of a smaller unit and a second mortar element 462 for fixing the second brick elements 461 to each other, and the second layered unit 470 is formed by alternately and repeatedly laminating a plurality of thin film-shaped inorganic elements 371 and organic elements 372.

The fifth embodiment is also advantageous in tension stress, compared to the first to third embodiments, due to the smaller hierarchical structure, and may achieve low moisture permeability and gas permeability due to a complicated gas and moisture path.

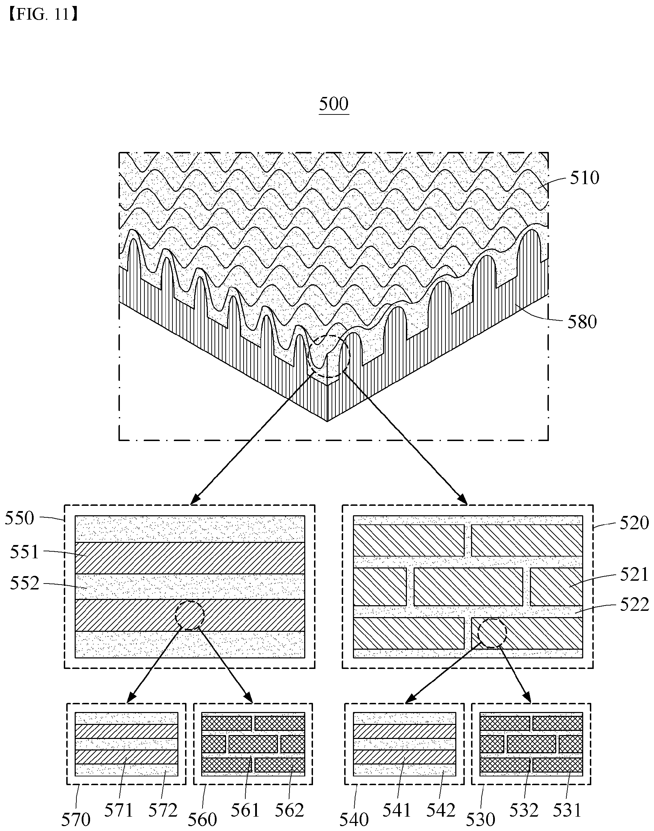

Referring to FIG. 11, a stretchable encapsulant 500 according to a preferred sixth embodiment of the present invention is schematically illustrated.

As shown in FIG. 11, a stretchable encapsulant 500 according to the sixth embodiment includes a wrinkle part 510 and a packaging part 580. The configuration of the packaging part 580 is similar to the configuration described above, so a detailed description thereof is omitted.

The wrinkle part 510 according to the sixth embodiment has a periodic three-dimensional protrusion shape as in the third embodiment, and the wrinkle part 510 has a brick-mortar structure 520 including bricks 521 and a mortar 522, or a layered structure 550 wherein an inorganic layer 551 and an organic layer 552 are alternately laminated. Here, each of the bricks 521 of the brick-mortar structure 520 includes a first brick-mortar unit 530 or first layered structure 540 of a smaller unit. In addition, each of the inorganic layer 551 of the layered structure 550 also includes a second brick-mortar unit 560 or second layered structure 570 of a smaller unit.

For reference, the first brick-mortar unit 530 includes a plurality of first brick elements 531 and a first mortar element 532 for fixing the plural first brick elements 531 to each other, and the first layered unit 540 is formed by alternately and repeatedly laminating a plurality of thin film-shaped inorganic brick layers 541 and organic brick layers 542.

In addition, the second brick-mortar unit 560 includes a plurality of second brick elements 561 of a smaller unit and a second mortar element 562 for fixing the second brick elements 561 to each other, and the second layered unit 570 is formed by alternately and repeatedly laminating a plurality of thin film-shaped inorganic elements 571 and organic elements 572.

The sixth embodiment is also advantageous in tension stress, compared to the first to third embodiments, due to the smaller hierarchical structure, and may achieve low moisture permeability and gas permeability due to a complicated gas and moisture path. That is, the performance of the encapsulant 500 may be further improved by providing the multi-layered wrinkle film 510 having a smaller multi-layer structure regardless of the shape of the wrinkle film 510.

While the present invention has been described referring to the preferred embodiment, those skilled in the art will appreciate that many modifications and changes can be made to the present invention without departing from the spirit and essential characteristics of the present invention.

## Claims

1. A stretchable encapsulant having a multi-layered structure, the stretchable encapsulant comprising:
a wrinkle part having a stretchable wrinkle structure; and
a packaging part being in close contact with the wrinkle part and configured to wrap the wrinkle part,
wherein the wrinkle part has a multi-layered structure wherein an organic material and an inorganic material are mutually laminated.

2. The stretchable encapsulant according to claim 1, wherein the wrinkle part has at least one shape of a periodic or aperiodic one-dimensional, two-dimensional or three-dimensional wave, wrinkle and protrusion shape.

3. The stretchable encapsulant according to claim 1, wherein the wrinkle part is prepared using at least one of nanoimprint, lithography, hot embossing and a wrinkle forming method using a previously stretched substrate.

4. The stretchable encapsulant according to claim 1, wherein the wrinkle part has a brick-mortar structure made of a plurality of bricks formed of the inorganic material; and a mortar formed of the organic material for fixing the plural bricks to each other.

5. The stretchable encapsulant according to claim 4, wherein the plural bricks comprise at least one of nanoclay comprising bentonite and montmorillonite and an oxide-based ceramic group comprising calcium carbonate, silica, alumina and titanium oxide, and
the mortar comprises one or more selected from a stretchable polymer group comprising polydimetylsiloxane (PDMS), polyurethane acrylate (PUA), perfluoropolyether (PFPE) and polyester (PE) or composite materials of the stretchable polymer materials and is made of a material having greater stretchability and elasticity than the bricks.

6. The stretchable encapsulant according to claim 4, wherein an aspect ratio of the plural bricks is 10 or more, and
a length of the plural bricks is more than 10 times greater than an interval between the plural bricks.

7. The stretchable encapsulant according to claim 4, wherein the plural bricks comprises:
a multi-layered brick-mortar unit comprising a plurality of brick elements formed of the inorganic material and a mortar element formed of the organic material to fix the plural brick elements to each other, or
a multi-layered unit wherein a plurality of inorganic brick layers formed of the inorganic material and a plurality of organic brick layers formed of the organic material are alternately and sequentially laminated.

8. The stretchable encapsulant according to claim 7, wherein the plural brick elements or the inorganic brick layer is formed of at least one of an oxide-based ceramic group comprising calcium carbonate, silica, alumina and titanium oxide, and
the mortar element or the organic brick layer comprises one or more selected from among a stretchable polymer group comprising polydimetylsiloxane (PDMS), polyurethane acrylate (PUA), perfluoropolyether (PFPE) and polyester (PE) or composite materials of the stretchable polymer materials and is made of a material having greater stretchability and elasticity than the plural brick elements or the inorganic brick layer.

9. The stretchable encapsulant according to claim 1, wherein the wrinkle part has a layered structure wherein a plurality of inorganic layers formed of the inorganic material and a plurality of organic layers formed of the organic material are alternately and sequentially laminated.

10. The stretchable encapsulant according to claim 9, wherein the plural inorganic layers comprise at least one of an oxide-based ceramic group comprising calcium carbonate, silica, alumina and titanium oxide, and
the plural organic layers comprise one or more selected from a stretchable polymer group comprising polydimetylsiloxane (PDMS), polyurethane acrylate (PUA), perfluoropolyether (PFPE) and polyester (PE) or composite materials of the stretchable polymer materials and are made of a material having greater stretchability and elasticity than the plural inorganic layers.

11. The stretchable encapsulant according to claim 9, wherein the plural inorganic layers are deposited by an Atomic Layer Deposition (ALD) process, and
the plural organic layers comprise a metalcone film comprising alucone or zincone and are deposited by a Molecular Layer Deposition (MLD) process.

12. The stretchable encapsulant according to claim 9, wherein pores are formed at different positions of the plural inorganic layers to extend a permeation path of gas and moisture.

13. The stretchable encapsulant according to claim 9, wherein the plural inorganic layers comprise:
a multi-layered brick-mortar unit comprising a plurality of brick elements formed of the inorganic material and a mortar element formed of the organic material to fix the plural brick elements to each other, or
a multi-layered unit wherein a plurality of inorganic elements formed of the inorganic material and a plurality of organic elements formed of the organic material are alternately and sequentially laminated.

14. The stretchable encapsulant according to claim 13, wherein the plural brick elements or the inorganic elements are formed of at least one of an oxide-based ceramic group comprising calcium carbonate, silica, alumina and titanium oxide, and
the mortar element or the organic elements comprise one or more selected from a stretchable polymer group comprising polydimetylsiloxane (PDMS), polyurethane acrylate (PUA), perfluoropolyether (PFPE) and polyester (PE) or composite materials of the stretchable polymer materials and are made of a material having greater stretchability and elasticity than the plural brick elements or the inorganic elements.

15. The stretchable encapsulant according to claim 1, wherein the packaging part is formed of a polymer material having greater elasticity and stretchability than the wrinkle part.

16. A stretchable encapsulant having a multi-layered structure, the stretchable encapsulant comprising:
a wrinkle part having a periodic or aperiodic pleated shape and being stretchable; and
a packaging part having greater elasticity and stretchability than the wrinkle part and being in close contact with the wrinkle part to wrap the wrinkle part,
wherein the wrinkle part has a multi-layered structure wherein an organic material and an inorganic material are mutually laminated.

17. The stretchable encapsulant according to claim 16, wherein the wrinkle part has at least one shape of a periodic or aperiodic one-dimensional, two-dimensional or three-dimensional wave, wrinkle and protrusion shape and is prepared using at least one of nanoimprint, lithography, hot embossing and a wrinkle forming method using a previously stretched substrate.

18. The stretchable encapsulant according to claim 16, wherein the inorganic material comprises at least one of nanoclay comprising bentonite and montmorillonite and an oxide-based ceramic group comprising calcium carbonate, silica, alumina and titanium oxide, and
the organic material comprises one or more selected from a stretchable polymer group comprising polydimetylsiloxane (PDMS), polyurethane acrylate (PUA), perfluoropolyether (PFPE) and polyester (PE) or composite materials of the stretchable polymer materials and is made of a material having greater stretchability and elasticity than the bricks.

19. The stretchable encapsulant according to claim 16, wherein the wrinkle part has a brick-mortar structure comprising a plurality of bricks formed of the inorganic material and a mortar formed of the organic material to fix the plural bricks to each other or a layered structure wherein a plurality of inorganic layers formed of the inorganic material and a plurality of organic layers formed of the organic material are alternately and sequentially laminated.

20. The stretchable encapsulant according to claim 19, wherein an aspect ratio of the plural bricks is 10 or more, and
a length of the plural bricks is more than 10 times greater than an interval between the plural bricks.

21. The stretchable encapsulant according to claim 19, wherein the plural bricks comprises:
a multi-layered brick-mortar unit comprising a plurality of brick elements formed of the inorganic material and a mortar element formed of the organic material to fix the plural brick elements to each other, or
a multi-layered unit wherein a plurality of inorganic brick layers formed of the inorganic material and a plurality of organic brick layers formed of the organic material are alternately and sequentially laminated.

22. The stretchable encapsulant according to claim 19, wherein the plural inorganic layers are deposited by an Atomic Layer Deposition (ALD) process, and
the plural organic layers comprise a metalcone film comprising alucone or zincone and are deposited by a Molecular Layer Deposition (MLD) process.

23. The stretchable encapsulant according to claim 19, wherein pores are formed at different positions of the plural inorganic layers to extend a permeation path of gas and moisture.

24. The stretchable encapsulant according to claim 19, wherein the plural inorganic layers comprise:
a multi-layered brick-mortar unit comprising a plurality of brick elements formed of the inorganic material and a mortar element formed of the organic material to fix the plural brick elements to each other, or
a multi-layered unit wherein a plurality of inorganic elements formed of the inorganic material and a plurality of organic elements formed of the organic material are alternately and sequentially laminated.
